# EUROPEAN PATENT SPECIFICATION

(11) **EP 1 656 591 B1**
(45) Date of publication and mention of the grant of the patent: **06.07.2011**
(21) Application number: 04744709.9
(22) Date of filing: 02.08.2004
(51) Int. Cl.: G03F 7/20

(54) **A METHOD OF RETAINING A SUBSTANCE ORIGINATING FROM A RADIATION SOURCE BY MEANS OF A FILTER**
VERFAHREN ZUM ZURÜCKHALTEN EINER IN EINER STRAHLUNGSQUELLE ERZEUGTEN SUBSTANZ MIT HILFE EINES FILTERS
PROCÉDÉ DE RÉTENTION D'UNE SUBSTANCE ORIGINAIRE D'UNE SOURCE DE RAYONNEMENT UTILISANT UN FILTRE

(30) Priority: 13.08.2003 EP 03102518
(43) Date of publication of application: 17.05.2006
(73) Proprietor: Philips Intellectual Property & Standards GmbH, 20099 Hamburg (DE); Koninklijke Philips Electronics N.V., 5621 BA Eindhoven (NL)
(72) Inventor: APETZ, Rolf, Theo, Anton,, 52066 Aachen (DE); JONKERS, Jeroen,, 52066 Aachen (DE)
(74) Representative: Volmer, Georg
(86) International application number: PCT/IB2004/051360
(87) International publication number: WO 2005/017624

(56) References cited:
- EP-A- 1 202 117
- WO-A-02/059905
- WO-A-03/092056

## Description

The invention relates to a method of retaining a substance originating from a radiation source as defined in the opening part of claim 1.

The invention also relates to the application of the method according to the invention in EUV lithography.

EUV lithography is to be used in the near future for mass manufacture of integrated circuits. Radiation sources are necessary for this which provide in particular a high output power for the irradiation of wafers. Two radiation source designs are particularly promising in this respect, given the present state of knowledge.

In the so-termed laser pulse plasma method, a substance is introduced in the form of a target into the focus of a pulsed laser beam. The target is evaporated owing to absorption of the laser beam. In addition, the substance is ionized so strongly at least in part that it emits rays in a wavelength range from 10 nm to 14 nm.

In the second type of radiation source, a substance in the form of a working gas is excited by means of electric discharge so as to form a plasma which emits EUV rays.

A particularly serious problem in these two radiation sources is formed by contamination of optical components inside an EUV lithography device owing to the deposition of substances originating from the radiation source.

JP 2000 349 009A discloses a filter which is permeable in particular to EUV rays and which retains the substance xenon. This filter is naturally unsuitable in particular for high-power radiation sources because particularly substances having a high conversion efficacy - i.e. the ratio of output power of the EUV rays to the energy coupled in - will block a collector mirror used for this purpose within a very short period. Thus, for example, a monoatomic layer of tin atoms on the collector mirror already reduces the reflection coefficient thereof by approximately 10%. The filter is in addition exposed to a very high radiant intensity, because the output power of the EUV rays passes through a comparatively small filter surface.

WO 03/092056 A1 discloses a method for retaining a substance originating from a radiation source by means of a filter which may be made of a thin film.

WO 02/059905 A discloses a method according to the preamble of claim 1. During operation of the filter the substances originating from the radiation source may deposit on the filter so that the transmission of the filter decreases. The filter has to be replaced from time to time for this reason.

EP 1 202 117 A1 discloses a further method for retaining a substance originating from a radiation source by means of a filter. The filter may be cooled by an appropriate cooling apparatus, which effectively dissipates heat accumulated in the transmission filter. This document proposes to use a rotation plate which additionally comprises an unused transmission filter. When debris is attached and the transmittance of the filter in operation is lowered, the rotation plate is rotated to replace the transmission filter with the unused transmission filter.

Furthermore, silicon nitride membranes in the form of windows have been used in electron microscopy. These windows are standardized to a maximum size of 25 mm² because of their low mechanical stability. This comparatively small window surface area inhibits an industrial application in EUV lithography.

Thin metal foils have been used for reducing radiation outside the wavelength range of EUV radiation and for protecting the optical systems of an EUV lithography device at least partly against contamination by the radiation source. A strip-shaped frame of nickel metal was adhered thereto to improve the handling properties. The adhesive used was epoxide.

It was found that such epoxide connections are unsuitable for use in high-power radiation sources under the prevailing thermal conditions.

The present invention accordingly has for its object to provide a method having the features referred to in the opening paragraph, which comprises technically simple means, can be used in particular for high-power radiation sources, and ensures a continuous transmission of the EUV radiation during operation.

According to the invention, this object is achieved by means of a method of retaining a substance originating from a radiation source by means of a filter, which filter comprises a layer that is transparent to extreme ultraviolet radiation, and which filter is resistant to temperatures to which the filter is heated during operation
wherein the temperature of the filter is adjusted such that the retained substance evaporates from the filter at a rate higher than that at which it is deposited thereon.

Due to the temperature resistance the filter can be positioned comparatively close to the radiation source. A high thermal loading capacity of the filter is necessary because of the absorption effects and the thermal transmission by the substance. A power transmitted thereby onto the filter lies in a range of approximately 1000 W. Assuming a radius of approximately 5 cm for the filter, it follows from the Stefan-Boltzmann law that the filter will reach a temperature of approximately 1225 K.

It is of particular advantage for the method if first the layer and subsequently a support structure for the thin layer are manufactured, or in reverse order, wherein the filter is constructed such that the layer is connected to the support structure in a manner that is resistant to the temperatures to which the filter is heated during operation.

As a result of this, the filter can be constructed with a large surface area. The radius of the filter thus increased reduces the thermal load on the filter, given a constant power of the radiation source. Filter life is considerably increased because its material is less strongly loaded.

Preferably, the layer is manufactured in a chemical and/or physical deposition process.

Obviously, all methods known to those skilled in the art may be used for manufacturing the thin layer. If manufacturing processes based on conventional thin-film techniques are used, however, very homogeneous layers can be generated on a suitable substrate, which layers, for example, have good optical properties, such as transmission of EUV radiation, over a large surface area within narrow limits. Conventional methods comprise, for example, CVD and PVD processes.

A particularly advantageous embodiment of the method provides that at least the layer comprises preponderantly zirconium, niobium, molybdenum, silicon, zirconium carbide (ZrC), zirconium dioxide, silicon carbide (SiC), silicon nitride (Si₃N₄), boron nitride (BN), or a combination thereof.

These materials are remarkable for their good optical properties such as, for example, a high transparency to EUV radiation and a high structural integrity of a thin layer manufactured therefrom over a wide temperature interval.

The layer and the support structure may be integrally manufactured.

This has the result that thermally induced stresses between the layer and the support structure are at least largely avoided in particular during heating and cooling-down of the filter according to the invention.

To ensure on the one hand a high transmission coefficient for the EUV radiation and on the other hand a high mechanical stability of the layer, the method is advantageously further developed such that a layer thickness of approximately 100 nm is achieved for the layer. Layer thicknesses in the range of 100 nm can be manufactured inexpensively and in a mass manufacturing process by means of the methods mentioned as examples above.

A particularly advantageous embodiment of the method provides that also the support structure comprises preponderantly zirconium, niobium, molybdenum, silicon, zirconium carbide (ZrC), zirconium dioxide, silicon carbide (SiC), silicon nitride (Si₃N₄), boron nitride (BN), or a combination thereof.

It is possible in particular with the use of the same materials, for example, to avoid thermal stresses between the thin layer and the support structure.

The method can be improved such that a thickness of approximately 1 µm up to 1 mm is set for the support structure.

The mechanical properties of this filter according to the invention can be adapted to the relevant application through variation of the thickness of the support structure.

It is obviously also possible to use materials for the filter which simplify handling, transport, and storage. For this purpose a material having a melting point of at least 1300 °C is chosen for the layer and the support structure.

The material is capable of improving both the optical and the mechanical properties of the inventive filter by means of dopants. A complete, substantially extremely thin coating of the material is capable of strongly simplifying in particular the handling of the filter outside a vacuum chamber in which the radiation source is accommodated. This coating serves for passivation, similar to an oxide layer on an aluminum component. The material, however, may equally well form part of the support structure which supplies additional mechanical stability, for example in the form of an outer frame.

The support structure is advantageously constructed as strips, for example forming a grid structure or honeycomb-type woven structure.

It is achieved with this construction that a load change occurring in the EUV lithography device is diverted via the support structure, for example in the case of a change in pressure conditions.

Such structures can be prepared, for example, by means of a suitable deposition on a previously manufactured thin film, which acts as the layer. It is provided in a further embodiment of the invention, however, that the woven structure is generated by means of erosion, laser processing, or photochemical etching. To achieve this, for example, a second layer of suitable thickness is provided on a thin layer, and the woven structure is obtained by means of the method mentioned above. Woven structures with a sufficient number of strips and/or nodes can be manufactured in this manner so as to suit the purpose in a particularly simple manner as regards production technology.

The woven structure may alternatively be manufactured by means of selective growth. For this purpose, a mask can first be generated on the layer, whereupon a material is deposited only where no mask is present, for example in an electroplating or CVD process. Thus, for example, a metal oxide layer may serve as the mask on the layer, and subsequently a metal, for example silicon, may be deposited as a support structure outside the metal oxide layer.

These structures may obviously also be made by any other technique known in the art.

The filter used in the present invention comprises a layer transparent to extreme ultraviolet radiation and is resistant to high temperatures. The radiation naturally transmits a high power - i.e. energy per unit time - to the filter, so that the latter is quickly heated during operation. It is obviously possible to provide a device for the filter by means of which a given operational temperature can be adjusted.

The energy hits the filter within very short periods, in particular in the case of pulsed radiation sources, which means that an increase in the filter surface area can reduce the load on the filter material further, in particular with a surface area of more than 25 mm². To obtain an improved mechanical stability of the filter, the filter may be constructed such that the layer is connected to a support structure in a high-temperature-resistant manner, or that the layer and the support structure are integrally manufactured.

This achieves a connection between the layer and the support structure which withstands the thermal loads coming from the radiation source for a long period.

Without limiting the general application of the method for retaining a substance originating from a radiation source, a particularly advantageous application of the method is found in a device for EUV lithography. The substance introduced by a radiation source is retained by the filter here, and a comparatively fast contamination of optical components is advantageously counteracted.

The application may be further developed with particular advantage in that the filter is operated at a temperature of approximately 900 °C to approximately 1300 °C. The filter can be positioned comparatively close to the radiation source because of the materials used for the layer and/or of a connection to the support structure that is resistant to high temperatures. These structural features remain intact during operation of the radiation source. In other words, the layer of the filter will neither evaporate nor melt under the temperature and pressure conditions prevailing in an industrial EUV exposure process.

The filter is adjustable such that the retained substance evaporates under the prevailing pressure. A comparatively fast evaporation of the substance from the filter means that a sufficiently large residual surface remains available for the passage of the EUV rays.

The temperature for the filter is adjustable such that the retained substance evaporates from the filter at a higher rate than that at which it is deposited thereon. This achieves a comparatively fast removal of the substance deposited on the filter. Short-term fluctuations in the transmission of the filter owing to absorption of rays by substance particles deposited on the filter can even be substantially completely prevented thereby.

To render possible a quantitative reduction in the amount of substance retained by the filter, the method may be advantageously further developed such that a foil trap is additionally arranged between the radiation source and the filter. The foil trap serves to reduce the quantity of substance originating from the radiation source in that it detracts kinetic energy from the substance particles. Various embodiments of the foil trap are the subject of earlier patent applications. The lower kinetic energy of the substance hitting the filter renders it possible to avoid sputtering, i.e. a removal of material, in particular from the layer.

The contamination of optical components of the lithography device and the wafer can be reduced by the use of the filter according to the invention in that the filter seals off the radiation source in the form of a window. Sealing-off by means of the filter creates a spatial separation between the radiation source and the optical components. The contamination of the optical components is almost completely suppressed thereby. The substance evaporating from the filter is also incapable of reaching the optical components.

Not only an increase in the energy coupled in and a suitable choice of the substance with a view to the conversion efficacy, but also an increase in the concentration of the substance in the radiation source serves to increase the power of the radiation source. The use of the filter for sealing off the radiation source renders it possible to design the operational method such that the substance reaches a partial pressure of approximately 10 Pa in the radiation source.

Further features and advantages of the invention will become apparent from the ensuing description of a number of embodiments and from the drawings to which reference is made and in which:
Fig. 1 is a diagrammatic cross-sectional view of a first embodiment of a filter arranged in the radiation path of a radiation source;
Fig. 1a is a side elevation, not true to scale, of a second embodiment;
Fig. 2 is a cross-sectional view of a semi-manufactured product in a third embodiment;
Fig. 2a is a perspective view of a fourth embodiment;
Fig. 2b is a vertical section of a fifth embodiment;
Fig. 3 is a diagrammatic side elevation of a first application; and
Fig. 4 is a further diagrammatic side elevation of a second application.

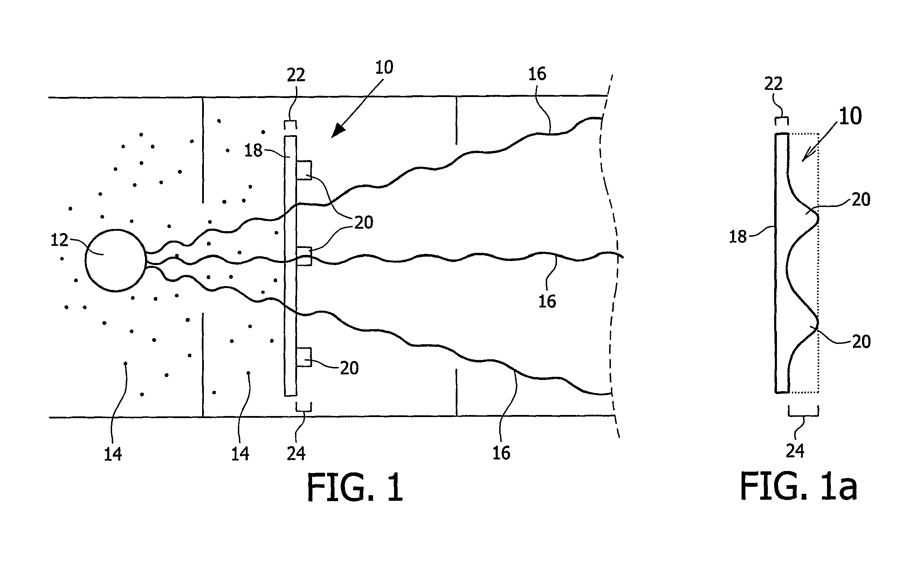

Equal reference symbols always refer to the same constructional features and always relate to Figs. 1 to 4, unless stated to the contrary.

In Fig. 1, a filter 10 is positioned for the purpose of retaining a substance 14 originating from a radiation source 12. The filter 10 comprises a thin layer 18 which is transparent to extreme ultraviolet radiation 16. The entire filter 10 is constructed so as to be resistant to high temperatures so that it can be used in particular at high temperatures.

The filter 10 was manufactured such that the thin layer 18 is connected to a support structure 20 in a high-temperature-resistant manner. The thin layer 18 and the support structure 20 may be manufactured one after the other without any particular sequence having to be observed.

The thin layer 18 may be manufactured by means of a chemical and/or physical deposition process, for example a CVD or PVD process. The thin layer 18 comprises mainly substances that have certain optical characteristics. These substances have a high transparency for EUV rays 16, while at the same time, for example, they may substantially absorb rays with a wavelength in the UV, IR and VIS ranges, as well as undesired wavelengths in the EUV range. The thin layer 18 accordingly comprises preponderantly zirconium, niobium, molybdenum, silicon, zirconium carbide, zirconium dioxide, silicon carbide, silicon nitride, boron nitride, or a combination thereof.

It is also possible to manufacture a filter 10 as an integral whole, as is shown in Fig. 1a. The thin layer 18 and the support structure 20 have been manufactured from a single layer of material having a material thickness indicated with dotted lines. The thin layer 18 has a layer thickness 22 of approximately 100 nm both in this embodiment and in the embodiment of a filter according to the invention shown in Fig. 1.

The embodiment of the support structure 20 shown in Fig. 1a is inevitably manufactured from the same material as the thin layer 18, but obviously the support structure 20 shown in Fig. 1 may also comprise preponderantly zirconium, niobium, molybdenum, silicon, zirconium carbide, zirconium dioxide, silicon carbide, silicon nitride, boron nitride, or a combination thereof. The support structure 20 is generated in dependence on the application such that it reaches a thickness 24 in a range from approximately 1 µm to 1 mm.

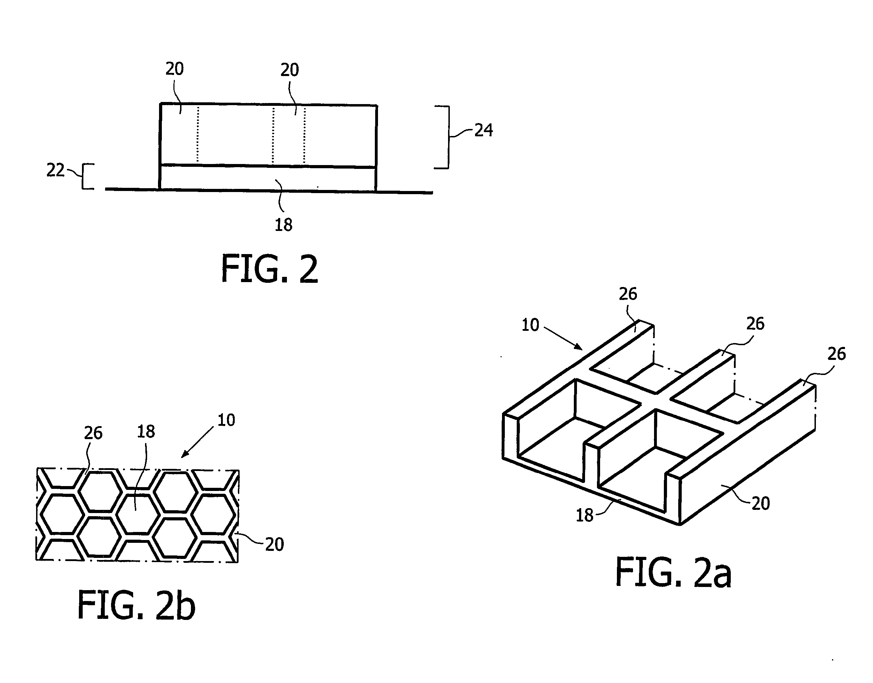

A method of manufacturing a filter 10 will now be explained in more detail with reference to Fig. 2 and Fig. 2a. On a thin layer 18 with a layer thickness 22 obtained by means of conventional thin layer techniques on a suitable substrate, a second layer with a thickness 24 is deposited in a high-temperature-resistant manner. The thin layer 18 may comprise, for example, preponderantly silicon nitride, and the layer used for manufacturing the support structure 20 indicated with dots may comprise, for example, preponderantly silicon. Both the thin layer 18 and the support structure 20 are generally manufactured from a material having a melting point of at least 1300 °C.

Further substances besides the main components of the layers may be provided, preferably by means of PVD and/or CVD methods in the form of dopants and/or coatings. The support structure 20 may be given a strip structure, for example under formation of a grid or honeycomb-type woven structure 26, by means of erosion, laser processing, or photochemical etching in a further process step.

This results, for example, in the grid-type woven structure 26 shown in Fig. 2a obtained by irradiation with UV light through a suitable mask and a subsequent etching with hydrogen fluoride. Only the upper layer of silicon shown in Fig. 2 is attacked and removed thereby in a chemically selective manner in the vacuum furnace under formation of volatile compounds such as SiF₄ and hydrogen. The silicon nitride layer serving as the thin layer 18 is not affected by the treatment.

Fig. 2b is a vertical section of a filter 10 manufactured by the method described above. A support structure 20 in the form of a honeycomb-type woven structure 26 is integrally arranged on the thin layer 18. Such a geometrical arrangement of the support structure 20, which may obviously alternatively take the form of circles, triangles, and the like, renders it possible also to manufacture filters 10 of particularly large surface area, for example with a radius of 10 cm, which have satisfactory optical and especially mechanical properties.

One of the mechanical properties is, for example, a low thermal stress upon a temperature change between the support structure 20 and the thin layer 18. Such a large-area filter 10 withstands mechanical loads that occur during storage, transport, and use in a radiation source 12, for example pressure differences arising during evacuation. Obviously, a bypass may also be provided between the radiation source 12 and a chamber containing the optical devices.

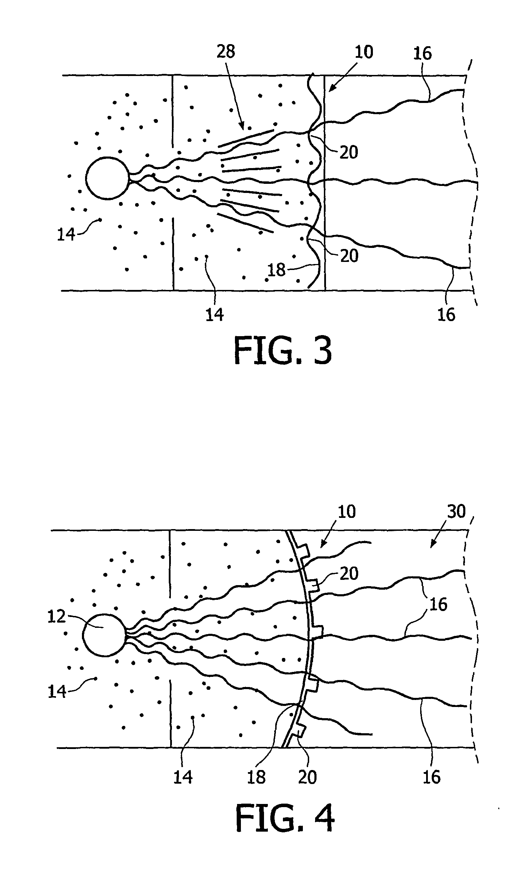

A first example of an application is shown in Fig. 3. A familiar foil trap 28 is arranged here between the filter 10 and the radiation source 12. Such an arrangement may be used in particular in EUV lithography. A substance 14 used in the radiation source 12 for generating the EUV radiation 16 reaches the filter 10. The filter 10 has a thin layer 18 and a support structure 20. At least the thin layer 18 is transparent to the EUV radiation 16. The filter 10 is heated by an absorption of radiation 16 at a surface of the filter 10 facing the radiation source. The filter is operated in a temperature interval from approximately 900 °C to 1300 °C. The temperature is adjusted during this such that the substance 14 retained by the filter 10 can evaporate under the prevailing pressure. A high transmission coefficient of the filter 10 can be ensured thereby in particular during operation of the radiation source 12. The foil trap 28 is capable, for example, of reducing the kinetic energy of the substance 14 migrating towards the filter 10 to such an extent that a sputtering of the thin layer 18 is substantially entirely suppressed.

Fig. 4 shows a second example of an application. The side elevation, not true to scale, shows a filter 10 whose temperature is adjustable by means of an additional device (not shown) such that the substance 14 used by the radiation source 12 is retained, while the substance 14 deposited on the filter 10 evaporates at a higher rate from the filter 10. A deposition of substance 14 on the filter 10, which is transparent to the rays 16, can be substantially fully suppressed, averaged over time, in this manner. As is apparent from Figs. 3 and 4, the filter 10 may be constructed in the manner of a window which seals off the radiation source 12 in the propagation direction of the rays 16. Said window may be arranged as a rectangle or substantially circular thanks to the support structure 20, which is either connected to the thin layer 18 in a manner resistant to high temperatures or is integral therewith. It is in particular the support structure 20 that renders it possible to realize an enlarged filter surface area, the filter 10 itself withstanding the mechanical loads during operation at a temperature in a range from approximately 900 °C to 1300 °C.

The mechanical stability of the filter 10 renders possible a spatial separation of the radiation source 12 and the substance 14 used for generating the radiation 16 from an optical system (not shown) of an EUV lithography device. The substance 14 in the radiation source 12 can be used as a working gas, for example in the form of a tin vapor, in particular through the supply of thermal energy, and can reach a partial pressure of approximately 10 Pa. The power of a high-power radiation source 12 can be increased thereby.

Obviously, a substantially transparent gas such as, for example, helium may be introduced into the chamber 30 for achieving a pressure equalization between the radiation source 12 and a chamber 30 arranged behind the filter 10 in the propagation direction of the radiation 16.

The invention provides a method of retaining a substance originating from a radiation source by means of a filter, which filter renders possible the use of in particular high-power radiation sources, safeguards a permanent transmission of the EUV radiation during operation, and in addition can be given a construction with a large surface area. The filter according to the invention, moreover, may be used for avoiding a contamination of optical components of an EUV lithography device.

### LIST OF REFERENCE NUMERALS

- 10: filter
- 12: radiation source
- 14: substance
- 16: radiation
- 18: thin layer
- 20: support structure
- 22: layer thickness
- 24: thickness
- 26: woven structure
- 28: foil trap
- 30: chamber

## Claims

1. A method of retaining a substance (14) originating from a radiation source (12) by means of a filter (10) which filter (10) comprises a layer (18) that is transparent to extreme ultraviolet (EUV) radiation (16), wherein the filter (10) is resistant to temperatures to which the filter (10) is heated during operation,
**characterized in that** the temperature of the filter (10) is adjusted such that the retained substance (14) evaporates from the filter (10) at a rate higher than that at which it is deposited thereon.

2. A method as claimed in claim 1, **characterized in that** the layer (18) is connected to a support structure (20) in a manner, that is resistant to the temperatures to which the filter is heated during operation or **in that** the layer (18) and the support structure (20) are manufactured as an integral whole.

3. A method as claimed in claim 2, **characterized in that** a material used for the layer (18) and the support structure (20) has a melting point of at least 1300 °C.

4. A method as claimed in any one of the claims 1 to 3, **characterized in that** at least the layer (18) is manufactured by means of a chemical and/or physical deposition process.

5. A method as claimed in any one of the claims 1 to 4, **characterized in that** at least the layer (18) comprises preponderantly zirconium, niobium, molybdenum, silicon, zirconium carbide (ZrC), zirconium dioxide, silicon carbide (SiC), silicon nitride (Si₃N₄), boron nitride (BN), or a combination thereof.

6. A method as claimed in any one of the claims 1 to 5, **characterized in that** the layer (18) has a layer thickness (22) of approximately 100 nm.

7. A method as claimed in any one of the claims 2 to 6, **characterized in that** the support structure (20) has a thickness (24) of approximately 1 µm to 1 mm.

8. A method as claimed in any one of the claims 2 to 7, **characterized in that** the support structure (20) is constructed in the form of strips, for example in the form of a grid-type or honeycomb-type woven structure (26).

9. A method as claimed in claim 8, **characterized in that** the woven structure (26) is obtained by means of erosion, laser processing, or photochemical etching.

10. A method as claimed in any of the preceding claims 1 to 9 the filter being operated in a device for EUV lithography.

11. A method as claimed in claim 10, **characterized in that** the filter (10) is operated at a temperature of approximately 900 °C to approximately 1300 °C.

12. A method as claimed in claim 10 or 11, **characterized in that** a foil trap (28) is additionally arranged between the radiation source (12) and the filter (10).

13. A method as claimed in claim 10 or 11, **characterized in that** the filter (10) seals off the radiation source (12) in the form of a window.

14. A method as claimed in claim 13, **characterized in that** the substance (14) in the radiation source (12) reaches a partial pressure of approximately 10 Pa.

## Patentansprüche

1. Verfahren zum Zurückhalten einer, einer Strahlungsquelle (12) entstammenden Substanz (14) mit Hilfe eines Filters (10), wobei das Filter (10) eine Schicht (18) umfasst, die für Extrem-Ultraviolett-(EUV) Strahlung (16) durchlässig ist, wobei das Filter (10) gegenüber Temperaturen, auf die das Filter (10) während des Betriebs erhitzt wird, beständig ist,
**dadurch gekennzeichnet, dass** die Temperatur des Filters (10) so eingestellt wird, dass die zurückgehaltene Substanz (14) von dem Filter (14) bei einer höheren Geschwindigkeit als dieser, bei der sie darauf abgelagert wird, verdampft.

2. Verfahren nach Anspruch 1, **dadurch gekennzeichnet, dass** die Schicht (18) mit einer tragenden Struktur (20) in einer Weise verbunden ist, die gegenüber Temperaturen, auf die das Filter während des Betriebs erhitzt wird, beständig ist, oder dass die Schicht (18) und die tragende Struktur (20) als ein integriertes Ganzes ausgebildet sind.

3. Verfahren nach Anspruch 2, **dadurch gekennzeichnet, dass** ein für die Schicht (18) und die tragende Struktur (20) verwendetes Material einen Schmelzpunkt von mindestens 1300°C hat.

4. Verfahren nach einem der Ansprüche 1 bis 3, **dadurch gekennzeichnet, dass** zumindest die Schicht (18) mit Hilfe eines chemischen und/oder physikalischen Abscheidungsprozesses vorgesehen wird.

5. Verfahren nach einem der Ansprüche 1 bis 4, **dadurch gekennzeichnet, dass** zumindest die Schicht (18) überwiegend Zirconium, Niobium, Molybdän, Silicium, Zirconiumcarbid (ZrC), Zirconiumdioxid, Siliciumcarbid (SiC), Siliciumnitrid (Si₃N₄), Bornitrid (BN) oder eine Kombination daraus enthält.

6. Verfahren nach einem der Ansprüche 1 bis 5, **dadurch gekennzeichnet, dass** die Schicht (18) eine Schichtdicke (22) von etwa 100 nm aufweist.

7. Verfahren nach einem der Ansprüche 2 bis 6, **dadurch gekennzeichnet, dass** die tragende Struktur (20) eine Dicke (24) von etwa 1 µm bis 1 mm aufweist.

8. Verfahren nach einem der Ansprüche 2 bis 7, **dadurch gekennzeichnet, dass** die tragende Struktur (20) in Form von Streifen, beispielsweise in Form einer gitterförmigen oder wabenförmigen Webstruktur (26) vorgesehen ist.

9. Verfahren nach Anspruch 8, **dadurch gekennzeichnet, dass** die Webstruktur (26) durch Erosion, Laserbearbeitung oder photochemisches Ätzen erhalten wird.

10. Verfahren nach einem der Ansprüche 1 bis 9, wobei das Filter in einer Einrichtung für EUV-Lithographie betrieben wird.

11. Verfahren nach Anspruch 10, **dadurch gekennzeichnet, dass** das Filter (10) bei einer Temperatur von etwa 900°C bis etwa 1300°C betrieben wird.

12. Verfahren nach Anspruch 10 oder 11, **dadurch gekennzeichnet, dass** zwischen der Strahlungsquelle (12) und dem Filter (10) zusätzlich ein Foil-Trap (28) angeordnet ist.

13. Verfahren nach Anspruch 10 oder 11, **dadurch gekennzeichnet, dass** das Filter (10) die Strahlungsquelle (12) in Form eines Fensters abschottet.

14. Verfahren nach Anspruch 13, **dadurch gekennzeichnet, dass** die Substanz (14) in der Strahlungsquelle (12) einen Partialdruck von etwa 10 Pa erreicht.

## Revendications

1. Procédé destiné à retenir une substance (14) provenant d'une source de rayonnement (12) au moyen d'un filtre (10), lequel filtre (10) comprend une couche (18) qui est transparente vis-à-vis du rayonnement ultraviolet extrême (EUV) (16), dans lequel le filtre (10) est résistant aux températures auxquelles le filtre (10) est chauffé pendant le fonctionnement,
**caractérisé en ce que** la température du filtre (10) est ajustée de sorte que la substance retenue (14) s'évapore du filtre (10) à un débit supérieur à celui auquel elle se dépose sur celui-ci.

2. Procédé selon la revendication 1, **caractérisé en ce que** la couche (18) est connectée à une structure de support (20) d'une manière qui est résistante aux températures auxquelles le filtre est chauffé pendant le fonctionnement ou **en ce que** la couche (18) et la structure de support (20) sont fabriquées d'un seul tenant.

3. Procédé selon la revendication 2, **caractérisé en ce qu'**un matériau utilisé pour la couche (18) et la structure de support (20) a un point de fusion d'au moins 1300°C.

4. Procédé selon l'une quelconque des revendications 1 à 3, **caractérisé en ce qu'**au moins la couche (18) est fabriquée au moyen d'un procédé de dépôt chimique et/ou physique.

5. Procédé selon l'une quelconque des revendications 1 à 4, **caractérisé en ce qu'**au moins la couche (18) comprend de manière prépondérante du zirconium, du niobium, du molybdène, du silicium, du carbure de zirconium (ZrC), du dioxyde de zirconium, du carbure de silicium (SiC), du nitrure de silicium (Si₃N₄), du nitrure de bore (BN), ou une combinaison de ceux-ci.

6. Procédé selon l'une quelconque des revendications 1 à 5, **caractérisé en ce qu'**au moins la couche (18) a une épaisseur de couche (22) d'environ 100 nm.

7. Procédé selon l'une quelconque des revendications 2 à 6, **caractérisé en ce que** la structure de support (20) a une épaisseur (24) d'environ 1 µm à 1 mm.

8. Procédé selon l'une quelconque des revendications 2 à 7, **caractérisé en ce que** la structure de support (20) est construite sous forme de bandes, par exemple sous forme d'une structure tissée en grille ou en nid d'abeille (26).

9. Procédé selon la revendication 8, **caractérisé en ce que** la structure tissée (26) est obtenue par érosion, par traitement laser ou par gravure photochimique.

10. Procédé selon l'une quelconque des revendications 1 à 9, le filtre étant utilisé dans un dispositif de lithographie EUV.

11. Procédé selon la revendication 10, **caractérisé en ce que** le filtre (10) est utilisé à une température d'environ 900°C à environ 1300°C.

12. Procédé selon la revendication 10 ou 11, **caractérisé en ce qu'**un collecteur à feuille (28) est en outre agencé entre la source de rayonnement (12) et le filtre (10).

13. Procédé selon la revendication 10 ou 11, **caractérisé en ce que** le filtre (10) scelle la source de rayonnement (12) sous la forme d'une fenêtre.

14. Procédé selon la revendication 13, **caractérisé en ce que** la substance (14) dans la source de rayonnement (12) atteint une pression partielle d'environ 10 Pa.
